# EUROPEAN PATENT SPECIFICATION

(11) **EP 2 147 860 B1**
(45) Date of publication and mention of the grant of the patent: **09.09.2015**
(21) Application number: 09251024.7
(22) Date of filing: 31.03.2009
(51) Int. Cl.: B64D 13/06, B64D 33/08, B64D 37/34, F24F 5/00, H01L 35/30

(54) **Heat exchanger assembly for an aircraft control**
Wärmetauscheranordnung für eine Flugzeugsteuerung
Ensemble échangeur thermique pour contrôle d'avion

(30) Priority: 21.07.2008 US 176522
(43) Date of publication of application: 27.01.2010
(73) Proprietor: Hamilton Sundstrand Corporation, Windsor Locks, CT 06096-1010 (US)
(72) Inventor: Lents, Charles E., Amston, Connecticut 06231 (US); Bailey, Trevor E., Tolland, Connecticut 06084 (US); Alahyari, Abbas A., Manchester, Connecticut 06040 (US)
(74) Representative: Tomlinson, Kerry John

(56) References cited:
- EP-A1- 1 902 950
- EP-A2- 1 905 986
- WO-A1-2008/061712
- DE-A1- 10 332 770
- GB-A- 2 333 352
- JP-A- 2004 071 764
- US-A- 5 584 183
- US-A1- 2003 005 706
- US-B1- 6 557 354

## Description

### BACKGROUND OF THE INVENTION

This invention relates to a heat exchanger for an aircraft control. An aircraft has a number of electronic controls used to control an operation of the aircraft. One such control manages the function of the aircraft engines and is commonly known as a Full Authority Digital Engine Control or FADEC. The FADEC is generally installed in an environment of the aircraft susceptible to both very high temperatures and very low temperatures. For example, the FADEC may be installed in the engine bay where large amounts of heat are generated during flight conditions. In these conditions, the FADEC requires a substantial amount of cooling to limit its operating temperature. When the aircraft is not in flight, however, the engine bay may be extremely cold when ambient air temperature is low. At these conditions, the FADEC requires very little, if any, cooling.

The FADEC, like many aircraft controls, is composed of electronic components that require moderate and uniform temperatures for optimal operation. The large temperature swings experienced by the FADEC are not conducive to the best performance of these temperature sensitive components. While there are electronic components that are capable of performing at the extreme temperature conditions of the aircraft, these components are generally very expensive and have relatively low performance (memory, process, or speed) compared to most modem electronics.

A need therefore exists for an assembly and technique that maintains the electronics of an aircraft control within their designed operating temperatures.

DE 10332770 A1, US 2003/005706 A1, and WO 2008/061712 A1 disclose prior art useful for understanding the present invention.

### SUMMARY OF THE INVENTION

A heat exchanger assembly for an aircraft control comprises: an aircraft control for controlling an operation of an aircraft; said aircraft control being in thermal communication with a first fluid; a first thermoelectric device configured to transfer heat between said first fluid and a closed loop containing a second fluid; a temperature sensor for sensing a temperature of said first fluid; and a temperature control configured to control said first thermoelectric device based on an input from said temperature sensor, wherein heat is transferred against a temperature gradient of said first fluid and said second fluid, so as to cool said first fluid when said second fluid has a higher temperature than said first fluid, and said second fluid is an aircraft engine fuel.

### BRIEF DESCRIPTION OF THE DRAWINGS

The various features and advantages of this invention will become apparent to those skilled in the art from the following detailed description of the currently preferred embodiment. The drawings that accompany the detailed description can be briefly described as follows:
Figure 1 illustrates a schematic view of a heat exchanger assembly for an aircraft control, showing first thermoelectric device, second thermoelectric device and third thermoelectric device.
Figure 2 illustrates a perspective view of the thermoelectric devices of Figure 1, including a plurality of flow conduits.
Figure 3 illustrates a close up view of the thermoelectric device of Figure 2, highlighting the flow conduits in relation to a thermoelectric device.
Figure 4 illustrates an alternative arrangement of flow conduits of Figure 3.
Figure 5 illustrates an exploded view of the thermoelectric device of Figure 3.

### DETAILED DESCRIPTION OF THE PREFERRED EMBODIMENT

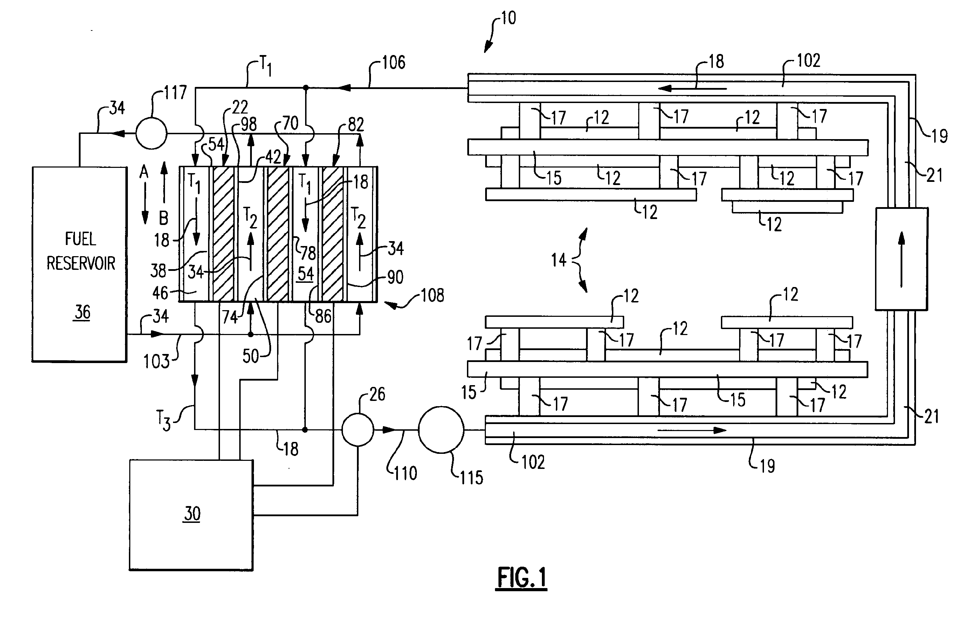

In Figure 1 there is shown heat exchanger assembly 10 for aircraft control 14. Figure 1 is a schematic and shows the general operation of heat exchanger assembly 10. As shown, aircraft control 14, such as a FADEC, for example, is composed of printed circuit boards 12. Printed circuit boards 12 are mounted to frame 19 in a tiered fashion. Printed circuit boards 12 are mounted to heat sinks 15 and conduction posts 17, which are all mounted to frame 19. This arrangement permits heat to be transferred between printed circuit boards 12 and frame 19.

Frame 19 has first fluid 18 to act as a heat exchanger for printed circuit boards 12 through heat sinks 15 and heat conduction posts 17. In this regard, first fluid 18 may be any of a variety of fluids, including aircraft engine fuel, ethylene glycol or any antifreeze. Frame 19 has fluid channel 21, an internal conduit that allows the circulation of first fluid 18 via pump 115 to thermoelectric assembly 108 and back to frame 19. First fluid 18 is contained in a closed fluid loop, here closed first loop 102.

At thermoelectric assembly 108, first fluid 18 exchanges heat with second fluid 34. Second fluid 34 is contained in another closed loop, second closed loop 103, which includes, by way of example, aircraft fuel reservoir 36, pump 117, and thermoelectric assembly 108. Pump 117 pumps second fluid 34, here aircraft engine fuel, through thermoelectric assembly 108 back to fuel reservoir 36.

The exchange of heat between first fluid 18 and second fluid 34 occurs through thermoelectric assembly 108. Normally, second fluid 34 is at a higher temperature than first fluid 18. Hence, transferring heat from first fluid 18, which is at a lower temperature than second fluid 34, is against the temperature gradient between the two fluids and generally would not occur. Thermoelectric assembly 108 is provided to thereby allow first fluid 18 to transfer heat to second fluid 34 against the temperature gradient of the two fluids.

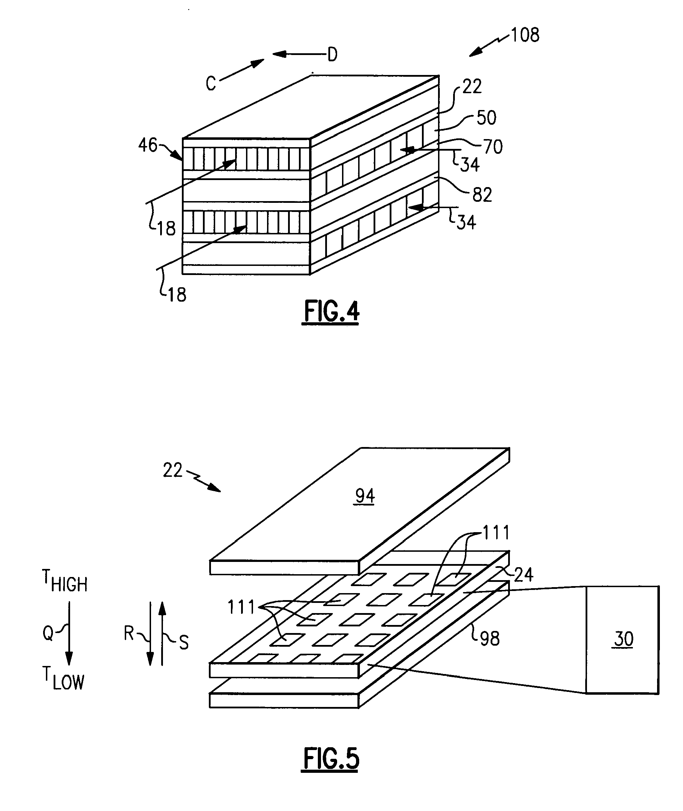

Thermoelectric assembly 108 has first thermoelectric device 22, second thermoelectric device 70 and third thermoelectric device 82. As shown in Figure 5, each thermoelectric device, such as first thermoelectric device 22, has thermoelectric elements 111 disposed on substrate 24. Each thermoelectric element 111 is configured to pump heat as known against a temperature gradient. Thermoelectric elements 111 are collectively oriented so that heat may be pumped either in the direction of arrow R or the direction of arrow S, both directions perpendicular to the mounting substrate 24. The direction can be controlled by controlling the direction of electric current flow for thermoelectric elements 111. Electric current flow in one direction will pump heat in the direction of arrow R while current flow in the opposite direction will pump heat in the direction of arrow S. Adjusting the level of electric current will adjust the rate of heat pumping.

First thermally conductive plate 94 and second thermally conductive plate 98, here made of aluminum, sandwich and encase substrate 24 so as to prevent fluid from damaging thermoelectric elements 111. Because first thermally conductive plate 94 and second thermally conductive plate 98 are both made of metal, they further provide a highly thermally conductive surface for the transmission of heat in the direction of arrow R or in the direction of arrow S. Hence, heat may be transferred between two fluids, such as first fluid 18 and second fluid 34, against the temperature gradient between the two fluids by controlling the electric current through thermoelectric elements 111.

The operation of heat exchanger assembly 10 will now be explained with reference to Figure 1. Excess heat from printed circuit boards 12 is passed to heat sinks 15 though heat conduction posts 17 and to frame 19 and ultimately to first fluid 18. First fluid 18 is circulated by pump 115 to thermoelectric assembly 108 along first flow path 106. There, first fluid 18 is passed in proximity to second fluid 34, which is circulated by pump 117 in the opposite direction as first fluid 18. Heat is transferred between first fluid 18 and second fluid 34 via first thermoelectric device 22, second thermoelectric device 70 and third thermoelectric device 82. These devices allow heat to be transferred even if the temperature of first fluid 18 is lower than the temperature of second fluid 34 at thermoelectric assembly 108. After exiting thermoelectric assembly 108, first fluid 18 has a temperature that helps maintain printed circuit boards 12 at their desired operating temperature.

With reference to first thermoelectric device 22 shown in Figure 1-3, the heat exchange between first fluid 18 and second fluid 34 occurs by passing first fluid 18 in the direction of arrow A through first plurality of flow conduits 46 along first thermoelectric device 22. As shown, second fluid 34 is channeled through second plurality of flow conduits 50 in the direction of arrow B, an opposite direction from the direction of flow of first fluid 18. Second plurality of flow conduits 50 is disposed on the other side of first thermoelectric device 22. First fluid 18 has temperature T₁ while second fluid 34 has temperature T₂. If temperature of T₂ is greater than temperature T₁, thermoelectric device 22 pumps heat from first fluid 18 to second fluid 34, even though second fluid 34 has a higher temperature. In this way, heat may be transferred from first fluid 18 to second fluid 34 so as to cool first fluid 18 coming from thermoelectric assembly 108 to temperature T₃, which is then returned to frame 19 along second flow path 110 so as to provide flow for moderating the temperature of printed circuit boards 12.

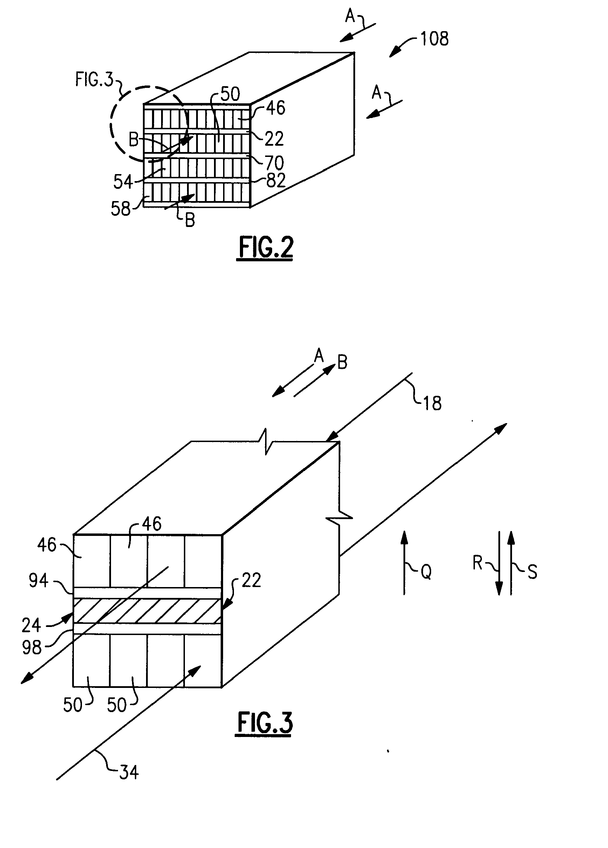

As shown in Figure 1, multiple layers of thermoelectric devices are used to improve the rate of heat exchange between first fluid 18 and second fluid 34. By way of example, thermoelectric assembly 108 has three thermoelectric devices, here first thermoelectric device 22, second thermoelectric device 70 and third thermoelectric device 82. First thermoelectric device has first side 38 and second side 42 while second thermoelectric device 70 has third side 74 and fourth side 78 and third thermoelectric device 82 has fifth side 86 and sixth side 90. On first side 38 is first plurality of flow conduits while between second side 42 and third side 74 is disposed second plurality of flow conduits 50. Between fourth side 78 and fifth side 86 is disposed third plurality of flow conduits 54. Fourth plurality of flow conduits 58 is on sixth side 90. This layering and structuring of flow conduits and thermoelectric devices can be seen in perspective view in Figure 2. There, as shown, flow conduits are stacked on thermoelectric devices. More or fewer layers of thermoelectric devices and flow conduits may be employed.

A close up view of first plurality of flow conducts 46, first thermoelectric device 22 and second plurality of flow conduits 50 is shown in Figure 3. There, it is shown that the temperature gradient between first fluid 18 and second fluid 34 is in the direction of arrow Q. In other words, first fluid 18 is cooler than second fluid 34. Thermoelectric device 22 allows heat to flow in the opposite direction of arrow Q, here the direction of arrow R so as to transfer heat from first fluid 18 to second fluid 34.

As shown Figure 1, each thermoelectric device, here first thermoelectric device 22, second thermoelectric device 70 and third thermoelectric device 82 are controlled by temperature control 30, which is in communication with temperature sensor 26. Temperature sensor 26 measures the temperature of first fluid 18 in closed loop 102 and provides an input for temperature control 30 to adjust current flow to the thermoelectric devices so as to maintain first fluid 18 at a temperature that will maintain printed circuit boards 12 within operational parameters.

There may be times when the temperature of first fluid 18 is too low, such as when the aircraft is inactive and ambient temperature is cold. In such an instance, first fluid 18 may, in fact, be at a lower temperature than second fluid 34. Then, temperature control 30 may reverse current to first thermoelectric device 22, second thermoelectric device 70 and third thermoelectric device 82 so that they transfer heat in the opposite direction, from second fluid 34 to first fluid 18. Temperature of first fluid 18 can be moderated in this fashion.

In Figure 1 and 3, to facilitate the exchange of heat, first fluid 18 is pumped in the direction of arrow A while second fluid 34 is pumped in the opposite direction, in the direction of arrow B. Figure 4 shows an alternative arrangement of flow conduits to create a cross-flow between first fluid 18 and second fluid 34. There, first fluid 18 is pumped in the direction of arrow C, say through first plurality of flow conduits 46, while second fluid 34 is pumped through second plurality of flow conduits 50 in the direction of arrow D, transverse to the direction of arrow C.

The aforementioned description is exemplary rather that limiting. Many modifications and variations of the present invention are possible in light of the above teachings. The preferred embodiments of this invention have been disclosed. However, one of ordinary skill in the art would recognize that certain modifications would come within the scope of this invention. Hence, within the scope of the appended claims, the invention may be practiced otherwise than as specifically described. For this reason the following claims should be studied to determine the true scope and content of this invention.

## Claims

1. A heat exchanger assembly (10) for an aircraft control (14), comprising:
an aircraft control (14) for controlling an operation of an aircraft;
said aircraft control being in thermal communication with a first fluid (8);
a first thermoelectric device (22) configured to transfer heat between said first fluid and a closed loop (103) containing a second fluid (34);
a temperature sensor (26) for sensing a temperature of said first fluid; and
a temperature control (30) configured to control said first thermoelectric device based on an input from said temperature sensor,
wherein heat is transferred against a temperature gradient of said first fluid and said second fluid, so as to cool said first fluid when said second fluid has a higher temperature than said first fluid, and said second fluid (34) is an aircraft engine fuel.

2. The assembly of Claim 1 wherein said first thermoelectric device has a first side (38) and a second side (42), said first fluid being in thermal communication with said first side and said second fluid being in thermal communication with said second side.

3. The assembly of Claim 2 including a first plurality of flow conduits and a second plurality of flow conduits, said first plurality of flow conduits being arranged to guide said first fluid across said first side (38) of said first thermoelectric device and said second plurality of flow conduits being arranged to guide said second fluid across said second side (42) of said first thermoelectric device.

4. The assembly of Claim 2 or 3 including a second thermoelectric device, said second thermoelectric device (70) spaced from said first thermoelectric device and having a third side (74) and fourth side (78), said third side facing said second side (42) of said first thermoelectric device, and said second fluid being disposed between said second side and said third side.

5. The assembly of Claim 4 including a third thermoelectric device (82) having a fifth side (86) and a sixth side (98), said fifth side facing said fourth (78) side of said second thermoelectric device wherein said second thermoelectric device is sandwiched between said first thermoelectric device and said third thermoelectric device.

6. The assembly of Claim 5 wherein said first fluid is on said first side, said second fluid disposed on said second side between said second side and said third side, said first fluid is also disposed between said fourth side and said fifth side, and said second fluid is also disposed on said sixth side.

7. The assembly of any preceding Claim including a first thermally conductive plate (94) and a second thermally conductive plate (98), said first thermoelectric device being sandwiched by said first thermally conductive plate and said second thermally conductive plate, said first thermally conductive plate and said second thermally conductive plate sealing said first thermoelectric device against fluid.

8. The assembly of any preceding Claim wherein said first fluid is disposed in a closed loop.

9. The assembly of Claim 3 wherein said first fluid is configured to flow along said first side in a first direction and said second fluid is configured to flow along said second side in a second direction, said first direction being different from said second direction; preferably wherein said first direction is generally opposite said second direction, alternatively wherein said first direction is transverse to said second direction.

10. A method of controlling a temperature for an aircraft control, comprising the steps of:
disposing a first fluid (18) proximate a control (14) for an aircraft, the first fluid being configured to absorb heat from the control for the aircraft;
providing a first flow path (106) for the first fluid to a thermoelectric device (108);
disposing a second fluid (34) contained in a closed loop (103) proximate the thermoelectric device, the second fluid being configured to absorb heat from the first fluid through the thermoelectric device;
providing a second flow path (110) for the first fluid from the thermoelectric device to the control; and
wherein the thermoelectric device is configured to transfer heat from the first fluid to the second fluid when the first fluid has a lower temperature than the second fluid thereby cooling the first fluid; and wherein said second fluid (34) is an aircraft engine fuel.

## Patentansprüche

1. Wärmetauscheranordnung (10) für eine Flugzeugsteuerung (14), umfassend:
eine Flugzeugsteuerung (14) zum Steuern eines Betriebs eines Flugzeugs;
wobei die Flugzeugsteuerung in Wärmeverbindung mit einem ersten Fluid (8) steht;
eine erste thermoelektrische Vorrichtung (22), die dazu konfiguriert ist, Wärme zwischen dem ersten Fluid und einem geschlossenen Kreislauf (103) zu übertragen, der ein zweites Fluid (34) enthält;
einen Temperatursensor (26) zum Messen einer Temperatur des ersten Fluids; und
eine Temperatursteuerung (30), die dazu konfiguriert ist, die erste thermoelektrische Vorrichtung auf Grundlage eines Eingangs vom Temperatursensor zu steuern,
wobei
Wärme entgegen einem Temperaturgradienten des ersten Fluids und des zweiten Fluids übertragen wird, um das erste Fluid zu kühlen, wenn das zweite Fluid eine höhere Temperatur als das erste Fluid aufweist, und das zweite Fluid (34) ein Flugzeugmotortreibstoff ist.

2. Anordnung nach Anspruch 1, wobei die erste thermoelektrische Vorrichtung eine erste Seite (38) und eine zweite Seite (42) aufweist, wobei das erste Fluid in Wärmeverbindung mit der ersten Seite steht und das zweite Fluid in Wärmeverbindung mit der zweiten Seite steht.

3. Anordnung nach Anspruch 2 aufweisend eine erste Mehrzahl von Durchflussleitungen und eine zweite Mehrzahl von Durchflussleitungen, wobei die erste Mehrzahl von Durchflussleitungen dazu angeordnet ist, das erste Fluid über die erste Seite (38) der ersten thermoelektrischen Vorrichtung zu leiten, und die zweite Mehrzahl von Durchflussleitungen dazu angeordnet ist, das zweite Fluid über die zweite Seite (42) der ersten thermoelektrischen Vorrichtung zu leiten.

4. Anordnung nach Anspruch 2 oder 3 aufweisend eine zweite thermoelektrische Vorrichtung, wobei die zweite thermoelektrische Vorrichtung (70) von der ersten thermoelektrischen Vorrichtung beabstandet ist und eine dritte Seite (74) und eine vierte Seite (78) aufweist, wobei die dritte Seite der zweiten Seite (42) der ersten thermoelektrischen Vorrichtung zugewandt ist und das zweite Fluid zwischen der zweiten Seite und der dritten Seite angeordnet ist.

5. Anordnung nach Anspruch 4 aufweisend eine dritte thermoelektrische Vorrichtung (82) mit einer fünften Seite (86) und einer sechsten Seite (98), wobei die fünfte Seite der vierten (78) Seite der zweiten thermoelektrischen Vorrichtung zugewandt ist, wobei die zweite thermoelektrische Vorrichtung zwischen der ersten thermoelektrischen Vorrichtung und der dritten thermoelektrischen Vorrichtung angeordnet ist.

6. Anordnung nach Anspruch 5, wobei das erste Fluid auf der ersten Seite ist, das zweite Fluid auf der zweiten Seite zwischen der zweiten Seite und der dritten Seite angeordnet ist, das erste Fluid auch zwischen der vierten Seite und der fünften Seite angeordnet ist, und das zweite Fluid auch auf der sechsten Seite angeordnet ist.

7. Anordnung nach einem der vorangehenden Ansprüche aufweisend eine erste wärmeleitfähige Platte (94) und eine zweite wärmeleitfähige Platte (98) wobei die erste thermoelektrische Vorrichtung zwischen der ersten wärmeleitfähigen Platte und der zweiten wärmeleitfähigen Platte angeordnet ist, wobei die erste wärmeleitfähige Platte und die zweite wärmeleitfähige Platte die wärmeleitfähige Platte gegenüber Fluid abdichten.

8. Anordnung nach einem der vorangehenden Ansprüche, wobei das erste Fluid in einem geschlossenen Kreislauf angeordnet ist.

9. Anordnung nach Anspruch 3, wobei das erste Fluid dazu konfiguriert ist, an der ersten Seite in einer ersten Richtung zu strömen, und das zweite Fluid dazu konfiguriert ist, an der zweiten Seite in einer zweiten Richtung zu strömen, wobei die erste Richtung sich von der zweiten Richtung unterscheidet; wobei vorzugsweise die erste Richtung der zweiten Richtung allgemein entgegengesetzt ist, wobei alternativ die erste Richtung quer zur zweiten Richtung ist.

10. Verfahren zum Steuern einer Temperatur einer Flugzeugsteuerung, folgende Schritte umfassend:
Anordnen eines ersten Fluids (18) in der Nähe einer Steuerung (14) für ein Flugzeug, wobei das erste Fluid dazu konfiguriert ist, Wärme von der Steuerung des Flugzeugs zu absorbieren;
Bereitstellen eines ersten Strömungswegs (106) von dem ersten Fluid an eine thermoelektrische Vorrichtung (108);
Anordnen eines zweiten Fluids (34), das in einem geschlossenen Kreislauf (103) enthalten ist, in der Nähe der thermoelektrischen Vorrichtung, wobei das zweite Fluid dazu konfiguriert ist, Wärme vom ersten Fluid durch die thermoelektrische Vorrichtung zu absorbieren;
Bereitstellen eines zweiten Strömungswegs (110) für das erste Fluid von der thermoelektrischen Vorrichtung zur Steuerung; und
wobei die thermoelektrische Vorrichtung dazu konfiguriert ist, Wärme vom ersten Fluid an das zweite Fluid zu übertragen, wenn das erste Fluid eine niedrigere Temperatur als das zweite Fluid aufweist, wodurch das erste Fluid gekühlt wird; und wobei das zweite Fluid (34) ein Flugzeugmotortreibstoff ist.

## Revendications

1. Ensemble formant un échangeur de chaleur (10) pour une régulation d'aéronef (14), comprenant :
une régulation d'aéronef (14) servant à réguler un fonctionnement d'un aéronef ;
ladite régulation d'aéronef étant en communication thermique avec un premier fluide (8) ;
un premier dispositif thermoélectrique (22) conçu pour transférer de la chaleur entre ledit premier fluide et une boucle fermée (103) contenant un deuxième fluide (34) ;
un capteur de température (26) servant à détecter une température dudit premier fluide ; et
une régulation de température (30) conçue réguler ledit premier dispositif thermoélectrique en fonction d'une entrée provenant dudit capteur de température, dans lequel la chaleur est transférée contre un gradient de température dudit premier fluide et dudit deuxième fluide, de manière à refroidir ledit premier fluide quand ledit deuxième fluide a une température plus élevée que ledit premier fluide, et où ledit deuxième fluide (34) est un combustible de moteur d'aéronef.

2. Ensemble selon la revendication 1, dans lequel ledit premier dispositif thermoélectrique a un premier côté (38) et un deuxième côté (42), ledit premier fluide étant en communication thermique avec ledit premier côté et ledit deuxième fluide étant en communication thermique avec ledit deuxième côté.

3. Ensemble selon la revendication 2 contenant une première pluralité de conduites d'écoulement et une deuxième pluralité de conduites d'écoulement, ladite première pluralité de conduites d'écoulement étant conçue pour guider ledit premier fluide à travers ledit premier côté (38) dudit premier dispositif thermoélectrique et ladite deuxième pluralité de conduites d'écoulement étant conçue pour guider ledit deuxième fluide à travers ledit deuxième côté (42) dudit premier dispositif thermoélectrique.

4. Ensemble selon la revendication 2 ou 3, comprenant un deuxième dispositif thermoélectrique, ledit deuxième dispositif thermoélectrique (70) espacé dudit premier dispositif thermoélectrique et comportant un troisième côté (74) et un quatrième côté (78), ledit troisième côté faisant face audit deuxième côté (42) dudit premier dispositif thermoélectrique, et ledit deuxième fluide étant disposé entre ledit deuxième côté et ledit troisième côté.

5. Ensemble selon la revendication 4, contenant un troisième dispositif thermoélectrique (82) comportant un cinquième côté (86) et un sixième côté (98), ledit cinquième côté faisant face au dit quatrième (78) côté dudit deuxième dispositif thermoélectrique, ledit deuxième dispositif thermoélectrique étant logé entre ledit premier dispositif thermoélectrique et ledit troisième dispositif thermoélectrique.

6. Ensemble selon la revendication 5, dans lequel ledit premier fluide se trouve sur ledit premier côté, ledit deuxième fluide étant sur ledit deuxième côté entre ledit deuxième côté et ledit troisième côté, ledit premier fluide étant aussi placé entre ledit quatrième côté et ledit cinquième côté, et ledit deuxième fluide étant aussi placé sur ledit sixième côté.

7. Ensemble selon l'une quelconque des revendications précédentes, comprenant une première plaque thermoconductrice (94) et une deuxième plaque thermoconductrice (98), ledit premier dispositif thermoélectrique étant retenu par ladite première plaque thermoconductrice et par ladite deuxième plaque thermoconductrice, ladite première plaque thermoconductrice et ladite deuxième plaque thermoconductrice étanchant ledit premier dispositif thermoélectrique contre le fluide.

8. Ensemble selon l'une quelconque des revendications précédentes, dans lequel ledit premier fluide se trouve dans une boucle fermée.

9. Ensemble selon la revendication 3, dans lequel ledit premier fluide est conçu pour s'écouler le long dudit premier côté dans une première direction et où ledit deuxième fluide est conçu pour s'écouler le long dudit deuxième côté dans une deuxième direction, ladite première direction étant différente de ladite deuxième direction ; de préférence, ladite première direction étant globalement opposée à ladite deuxième direction, sinon ladite première direction étant transversale à ladite deuxième direction.

10. Procédé de régulation d'une température pour une régulation d'aéronef, comprenant les étapes suivantes :
disposer un premier fluide (18) à côté d'une régulation (14) pour un aéronef, le premier fluide étant conçu pour absorber de la chaleur à partir de la régulation destinée à l'aéronef;
prévoir une première voie d'écoulement (106) pour le premier fluide vers un dispositif thermoélectrique (108) ;
disposer un deuxième fluide (34) contenu dans une boucle fermée (103) à proximité du dispositif thermoélectrique, le deuxième fluide étant conçu pour absorber de la chaleur à partir du premier fluide à travers le dispositif thermoélectrique ;
l'utilisation d'une deuxième voie pour fluide (110) pour le premier fluide à partir du dispositif thermoélectrique jusqu'à la régulation ; et
le dispositif thermoélectrique étant conçu pour transférer de la chaleur du premier fluide au deuxième fluide lorsque le premier fluide a une température inférieure à celle du deuxième fluide, ce qui refroidit le premier fluide ; et où ledit deuxième fluide (34) est un combustible de moteur d'aéronef.
